# EUROPEAN PATENT APPLICATION

(11) **EP 4 794 464 A2**
(43) Date of publication of application: **19.08.2026**
(21) Application number: 26189610.4
(22) Date of filing: 22.07.2024
(51) Int. Cl.: H05K 9/00

(54) **ELECTRONIC DEVICE**

(30) Priority: 17.06.2024 CN 202410784089
(62) Document number(s) of the earlier application(s) in accordance with Art. 76 EPC: 24919135.4 / 4 697 880
(71) Applicant: Shanghai Moorewatt Energy Technology Co., Ltd., Shanghai 200131 (CN)
(72) Inventor: LAI, Guiren, Shanghai, 200131 (CN)
(74) Representative: Bryn Aarflot AS

(57) **Abstract**

The present disclosure relates to an electronic device. The electronic device includes a housing, a heat spreader plate and a circuit board. The housing includes an upper housing and a lower housing. The lower housing, the heat spreader plate, the circuit board and the upper housing are arranged in sequence along a first direction. A projection of the heat spreader plate along the first direction covers at least a target region of the circuit board. A heat dissipation for circuit boards can be achieved and manufacturing costs can be reduced.

## Description

### RELATED APPLICATIONS

This disclosure claims priority to Chinese patent application No. 2024107840899, entitled "ELECTRONIC DEVICE", filed on June 17, 2024, which is hereby incorporated by reference in its entirety.

### TECHNICAL FIELD

The present disclosure relates to the technical field of hardware heat dissipation, and in particular to an electronic device.

### BACKGROUND

A power converter can convert direction current (DC) into alternating current (AC). The DC terminal (i.e., input) of the power converter is connected to a DC source (a photovoltaic module), and the AC terminal (i.e., output) of the power converter can be connected to an AC grid and loads. In the power converter, components on a circuit board generate a lot of heat in operation. If the heat cannot be dissipated in time, the components on the circuit board will be damaged, thus causing the entire power converter to malfunction.

### SUMMARY

In view of this, it is necessary to provide an electronic device that can dissipate heat for a circuit board to address a problem of heat dissipation.

An electronic device includes: a housing, a heat spreader plate and a circuit board. The housing includes an upper housing and a lower housing. The lower housing, the heat spreader plate, the circuit board and the upper housing are arranged in sequence along a first direction. A projection of the heat spreader plate along the first direction covers at least a target region of the circuit board.

In an embodiment, the target region includes a first region on the circuit board, wherein components on the first region have a power consumption greater than a first preset threshold.

In an embodiment, the target region includes a primary side region on the circuit board, and a second region in a secondary side region, wherein components on the second region have a power consumption greater than a second preset threshold.

In an embodiment, an electromagnetic interference (EMI) filter circuit region in a secondary side region on the circuit board is located outside the target region.

In an embodiment, a transformer is arranged in the target region, and the transformer is connected across a primary side region and a secondary side region.

In an embodiment, a first group of through holes are formed in the heat spreader plate, and projections of the first group of through holes along the first direction are located in the primary side region, and the first group of through holes are configured for insulation.

In an embodiment, the first group of through holes include at least one of: a first-type through hole, a second-type through hole, a third-type through hole, a fourth-type through hole, or a fifth-type through hole. A projection of the first-type through hole along the first direction corresponds to a communication transformer pin in a power line communication (PLC). A projection of the second-type through hole along the first direction corresponds to a capacitor pin. A projection of the third-type through hole along the first direction corresponds to a connector. A projection of the fourth-type through hole along the first direction corresponds to a pin of the transformer in the primary side region. A projection of the fifth-type through hole along the first direction correspond to a sampling pin of a current transformer (CT).

In an embodiment, a second group of through holes are formed in the heat spreader plate, projections of the second group of through holes along the first direction are located in the secondary side region, and the second group of through holes correspond to component pins in the secondary side region.

In an embodiment, the second group of through holes include a sixth-type through hole; and a projection of the sixth-type through hole along the first direction corresponds to a pin of the transformer in the secondary side region.

In an embodiment, the heat spreader plate includes a thermal conductive adhesive coating region, and a projection of the thermal conductive adhesive coating region along the first direction coincides with high-power consumption component regions.

In an embodiment, the thermal conductive adhesive coating region includes a first coating region and a second coating region. A projection of the first coating region along the first direction coincides with a high-power consumption component region in the primary side region. A projection of the second coating region along the first direction coincides with a high-power consumption component region in the secondary side region.

In an embodiment, a first protrusion and a second protrusion are disposed on the heat spreader plate. The first coating region is formed on the first protrusion, and the second coating region is formed on the second protrusion.

In an embodiment, the heat spreader plate is provided with a protrusion, and a projection of the protrusion along the first direction coincides with a high-power consumption component region.

In an embodiment, a thickness of the heat spreader plate is greater than or equal to 2 mm.

In an embodiment, the heat spreader plate is made of metal material.

In an embodiment, a first positioning post is disposed on one side of the lower housing proximate to the heat spreader plate and is adapted to extend along the first direction; a first positioning hole is formed in the heat spreader plate, a limiting hole is formed in the circuit board, and the first positioning post is adapted to pass through the first positioning hole and the limiting hole in sequence.

In an embodiment, the first positioning post includes a support pedestal, the circuit board is supported on the support pedestal, and a height of the support pedestal is greater than a thickness of the heat spreader plate.

In an embodiment, a second positioning post is disposed on the lower housing, a second positioning hole is formed on the heat spreader plate, the second positioning post is adapted to be inserted into the second positioning hole, and a height of the second positioning post is the same as a thickness of the heat spreader plate.

The electronic device includes the housing, the heat spreader plate and the circuit board. The housing includes the upper housing and the lower housing. The lower housing, the heat spreader plate, the circuit board and the upper housing are arranged in sequence along the first direction. The projection of the heat spreader plate along the first direction covers at least a target region of the circuit board. In this solution, the heat spreader plate is arranged in the electronic device, and the projection of the heat spreader plate along the first direction covers at least the target region of the circuit board, so that the heat spreader plate can achieve the heat dissipation for the circuit board, and compared with the solution of arranging multiple heat spreader plates, the manufacturing costs can be reduced and the manufacturing process can be simplified.

In the above embodiments, the projection of the heat spreader plate along the first direction covers at least the target region of the circuit board. In this case, the heat spreader plate can be regarded as a shielding cover for the EMI generated by the circuit board, and can take an effect of shielding the EMI.

In the above embodiments, a loop is formed by the heat spreader plate, the circuit board, and parasitic capacitance between the heat spreader plate and the circuit board, and the EMI generated by the circuit board is confined in the loop, which can reduce the electromagnetic waves emitted outward, thereby restraining the EMI.

In the above embodiments, the heat spreader plate is a continuous whole heat spreader plate, and the EMI generated by the circuit board can circle in the plane formed by the heat spreader plate, which can reduce the electromagnetic waves emitted outward, thereby restraining the EMI.

### BRIEF DESCRIPTION OF THE DRAWINGS

FIG. 1 is a schematic structural view of an electronic device;
FIG. 2A is a first schematic view showing a circuit board 12 and a heat spreader plate 11;
FIG. 2B is a schematic view showing an arrangement of the heat spreader plate 11 and an electromagnetic interference (EMI) filter circuit;
FIG. 3 is a second schematic view showing the circuit board 12 and the heat spreader plate 11;
FIG. 4 is a schematic view of a partial structure of the electronic device;
FIG. 5A is a schematic view showing a fixing structure between a lower housing 14 and the heat spreader plate 11;
FIG. 5B is a partial enlarged view of a portion M in FIG. 5A;
FIG. 5C is a partial enlarged view of a portion N in FIG. 5A;
FIG. 5D is a partial enlarged view of a portion S in FIG. 5A;
FIG. 6 is a schematic structural view of a positioning member 56.

The drawings include: heat spreader plate 11, circuit board 12, upper housing 13, lower housing 14, first direction X, first dashed region 121, second dashed region 122, third dashed region 123, first-type through hole 31, second-type through hole 32, third-type through hole 33, fourth-type through hole 34, sixth-type through hole 35, fifth-type through hole 36, adhesive leakage hole 37, first coating region 421, second coating region 422, high-power consumption component region 431 in primary side region, high-power consumption component region 432 in secondary side region, first protrusion 441, second protrusion 442, EMI filter circuit region 45, first positioning post 51, first positioning hole 52, limiting hole 53, second positioning post 54, second positioning hole 55, positioning member 56, support portion 561, abutment portion 562.

### DETAILED DESCRIPTION OF THE EMBODIMENTS

In order to make the above objectives, features and advantages of the present disclosure clearer and better understood, specific implementations of the present disclosure are described in detail hereinafter with reference to the accompanying drawings. In the following description, many specific details are set forth to make the present disclosure to be fully understood. However, the present disclosure can be implemented in many other ways different from those described herein, and those skilled in the art can make similar improvements without departing from the connotation of the present disclosure. Therefore, the present disclosure is not limited by the specific embodiments disclosed below.

In the description of the present disclosure, it should be understood that if the terms "center", "longitudinal", "transverse", "length", "width", "thickness", "upper'', "lower", "front", "rear", "left", "right", "vertical", "horizontal", "top", "bottom", "inner", "outer", "clockwise", "counterclockwise", "axial", "radial", "circumferential", etc. are used, the orientation or position relationships indicated by these terms are based on the orientation or position relationships shown in the accompanying drawings and are merely intended to facilitate the description of the present disclosure and simplify the description, rather than indicating or implying that the indicated device or element must have a particular orientation or be constructed and operated in a particular orientation, and therefore are not to be interpreted as limitations on the present disclosure.

In addition, if the terms "first" and "second" are used, these terms are used for descriptive purposes only but cannot be interpreted as indicating or implying relative importance or implicitly specifying the number of indicated technical features. Thus, the features defined as "first" and "second" may explicitly or implicitly include at least one of these features. In the description of the present disclosure, if the term "plurality" is described, the "plurality" means at least two, such as two, and three, etc., unless otherwise clearly and specifically defined.

In the present disclosure, unless otherwise clearly specified and limited, if the terms "mount", "connection", "communication", "fix", etc., are used, these terms should be understood in a broad sense, for example, may be a fixed connection or a detachable connection, or an integrated connection; or may be a mechanical connection or an electrical connection; or may be a direct connection or an indirect connection through an intermediate medium; or may be an internal communication between two elements or an interaction relationship between two elements, unless otherwise clearly defined. Those of ordinary skill in the art can understand the specific meanings of the above terms in the present disclosure according to specific situations.

In the present disclosure, unless otherwise clearly specified and limited, if there is a description that a first feature is "above" or "under" a second feature, etc., or similar description, it may mean that the first and second features are in direct contact, or the first and second features are in indirect contact through an intermediate medium. Moreover, the first feature being "on top of", "above" and "over" the second feature may mean that the first feature is directly above or obliquely above the second feature, or simply means that the horizontal height of the first feature is greater than that of the second feature. The first feature being "under", "beneath" and "below" the second feature may mean that the first feature is directly below or obliquely below the second feature, or simply means that the horizontal height of the first feature is less than the second feature.

It should be noted that if an element is referred to as being "fixed to" or "disposed on" another element, the element may be directly on the other element or there may be an intermediate element. If an element is considered to be "connected to" another element, the element may be directly connected to the other element or there may be an intermediate element as well. If any, the terms "vertical", "horizontal", "upper", "lower", "left", "right" and similar expressions used in this disclosure are for illustrative purposes only and do not represent the only embodiment.

A power converter is a power conversion device used to convert electrical energy from one form to another to achieve energy transmission and energy control under different power requirements. The power converter can be a micro-inverter, or an energy storage converter, etc. Exemplarily, the micro-inverter can convert direct current (DC) into alternating current (AC). The DC terminal (i.e., input) of the micro-inverter is connected to a DC source (e.g., a photovoltaic module), and the AC terminal (i.e., output) of the power converter can be connected to an AC grid and an AC device.

Exemplarily, in the micro-inverter, components on a circuit board generate a large amount of heat in operation. If the heat cannot be dissipated in time, the components on the circuit board will be damaged, thus causing the entire micro-inverter to malfunction.

In the present disclosure, the electronic device may be a power converter, for example, a micro-inverter, or a Power Conversion System (PCS) converter, etc. In an embodiment of the present disclosure, a heat spreader plate is arranged in the electronic device, so that the heat spreader plate can dissipate heat for the circuit board in time.

It should be noted that the heat spreader plate of the embodiment of the present disclosure can also be applied to, besides the power converter, any electronic device provided with a circuit board.

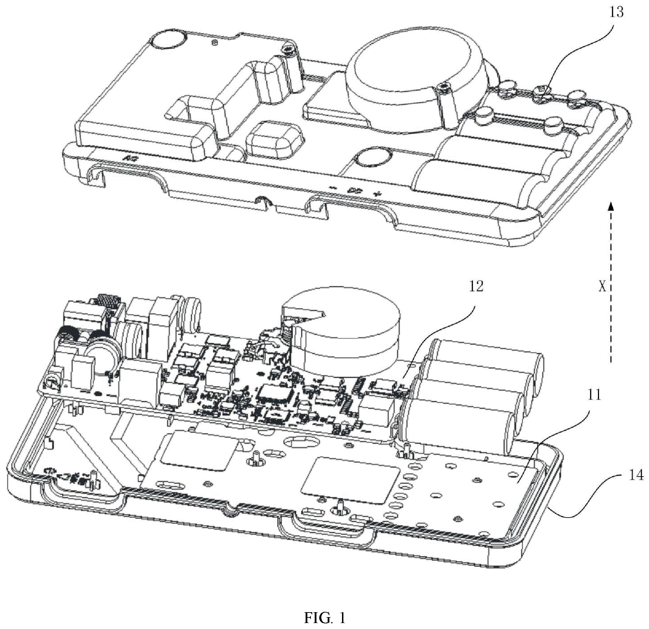

Referring to FIG. 1, FIG. 1 is a schematic structural view of an electronic device in an embodiment of the present disclosure. The electronic device includes: a housing, a heat spreader plate 11 and a circuit board 12. The housing includes an upper housing 13 and a lower housing 14. The lower housing 14, the heat spreader plate 11, the circuit board 12 and the upper housing 13 are arranged in sequence along a first direction X (i.e., a direction indicated by a dotted arrow in FIG. 1). A projection of the heat spreader plate 11 along the first direction X covers at least a target region of the circuit board 12.

As shown in FIG. 1, the electronic device is provided with the heat spreader plate 11, and the projection of the heat spreader plate 11 along the first direction X covers at least the target region of the circuit board 12, so that the heat spreader plate 11 can dissipate heat for the circuit board 12, and, compared with a solution of arranging multiple heat spreader plates, can reduce the manufacturing cost.

In some embodiments, the circuit board 12 may be a printed circuit board assembly (PCBA). The target region may be the entire region or a partial region of the circuit board 12. When the target region is the partial region of the circuit board 12, the projection of the heat spreader plate 11 along the first direction X can cover the partial region of the circuit board 12, thereby dissipating heat of the partial region on the circuit board, and compared with a solution that the entire region of the circuit board 12 is covered, the size of the heat spreader plate 11 may be reduced, the manufacturing cost may be reduced, and the manufacturing process may be simplified.

In the above embodiment, the projection of the heat spreader plate 11 along the first direction X covers at least the target region of the circuit board 12, and a loop is formed by the heat spreader plate 11, the circuit board 12, and parasitic capacitance between the circuit board 12, and electromagnetic interference (EMI) generated by the circuit board 12 is confined in the loop, which can reduce the electromagnetic waves emitted outward, thereby restraining the EMI. In addition, the heat spreader plate 11 is a continuous whole heat spreader plate, and the EMI generated by the circuit board 12 can be confined in the plane formed by the heat spreader plate 11, which can reduce the electromagnetic waves emitted outward, thereby restraining the EMI. In this case, the heat spreader plate 11 can be regarded as a shielding cover for the EMI generated by the circuit board 12, and can take an effect of shielding the EMI.

### Embodiment 1

The target region includes a first region on the circuit board 12, and components on the first region have a power consumption greater than a first preset threshold. On the circuit board 12, the components having the power consumption greater than the first preset threshold generate more heat due to a large power consumption, therefore the temperature of the first region will be relatively high, and the heat dissipation requirement thereof is also relatively high. The projection of the heat spreader plate 11 along the first direction covers the first region, which can make the heat dissipation effect of the first region better, thereby ensuring a normal operation of the components on the first region and prolonging the service life of the operating components.

On the circuit board 12, the components having power consumption greater than the first preset threshold can be defined as high-power consumption components, such as metal oxide semiconductor field effect transistors (MOSFETs). The first preset threshold can be set according to a relationship between power consumption and heat generation of a component in practice, as well as a requirement for heat dissipation in the embodiments of the present disclosure, which is not limited in the embodiments of the present disclosure.

It should be noted that the projection of the heat spreader plate 11 along the first direction X covering at least the target region of the circuit board 12 can be understood as follows: in embodiment 1, the projection of the heat spreader plate 11 along the first direction X not only covers the first region on the circuit board 12, but also can cover some other regions on the circuit board 12.

### Embodiment 2

The circuit board 12 includes a primary side region and a secondary side region. The primary side region is a region where a DC circuit of the circuit board 12 is located, and the secondary side region is a region where an AC circuit of the circuit board 12 is located.

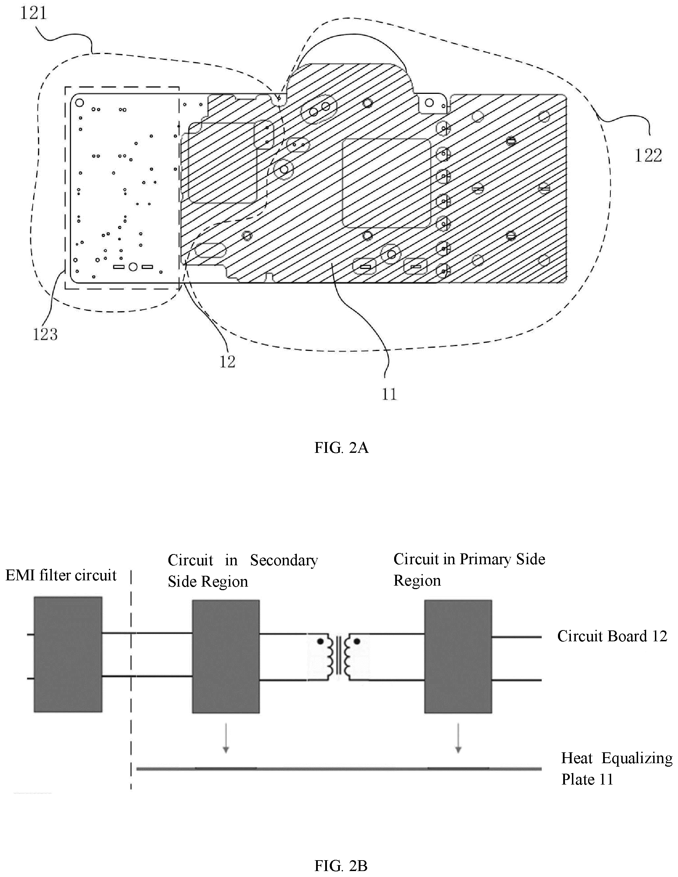

Exemplarily, FIG. 2A is a first schematic view showing a circuit board 12 and a heat spreader plate 11. As shown in FIG. 2A, a region within a first dashed region 121 on the circuit board 12 is the secondary side region, and a region within a second dashed region 122 on the circuit board 12 is the primary side region. The target region includes the primary side region on the circuit board 12, and a second region in the secondary side region on the circuit board 12. The components on the second region have a power consumption greater than a second preset threshold. The second region may be a region within the first dashed region 121 on the circuit board 12 shown in FIG. 2A and covered by the projection of the heat spreader plate 11.

It should be noted that the first dashed region 121 and the second dashed region 122 are exemplary region divisions. The boundary of the first dashed region 121 is not an exact boundary of the secondary side region, and the boundary of the second dashed region 122 is not an exact boundary of the primary side region either. The first dashed region 121 is only an exemplary region in which the secondary side region may be located, and the second dashed region 122 is only an exemplary region in which the primary side region may be located.

In some embodiments, the target region includes the second region in the secondary side region on the circuit board 12, where the components have the power consumption greater than the second preset threshold. The components in the second region on the circuit board 12 have the power consumption greater than the second preset threshold and generate more heat due to the large power consumption, therefore the temperature of the second region will be relatively high, and the heat dissipation requirement thereof is also relatively high. The projection of the heat spreader plate 11 along the first direction covers the second region, which can make the heat dissipation effect of the second region better, thereby ensuring a normal operation of the components on the second region and prolonging the service life of the operating components.

The second preset threshold can be set according to a relationship between power consumption and heat generation of a component in practice, as well as the requirement for heat dissipation in the embodiments of the present disclosure, which is not limited in the embodiments of the present disclosure.

### Embodiment 3

As shown in FIG. 2A, the target region excludes an EMI filter circuit region in the secondary side region on the circuit board. The EMI filter circuit region is a region on the circuit board 12, which is within the first dashed region 121 shown in FIG. 2A and is not covered by the projection of the heat spreader plate 11. The EMI filter circuit region may be within the third dashed region 123 shown in FIG. 2A.

It should be noted that the third dashed region 123 is an exemplary region division, and the boundary of the third dashed region 123 is not an exact boundary of the EMI filter circuit region, and the third dashed region 123 is only an exemplary region within which the EMI filter circuit region may be located.

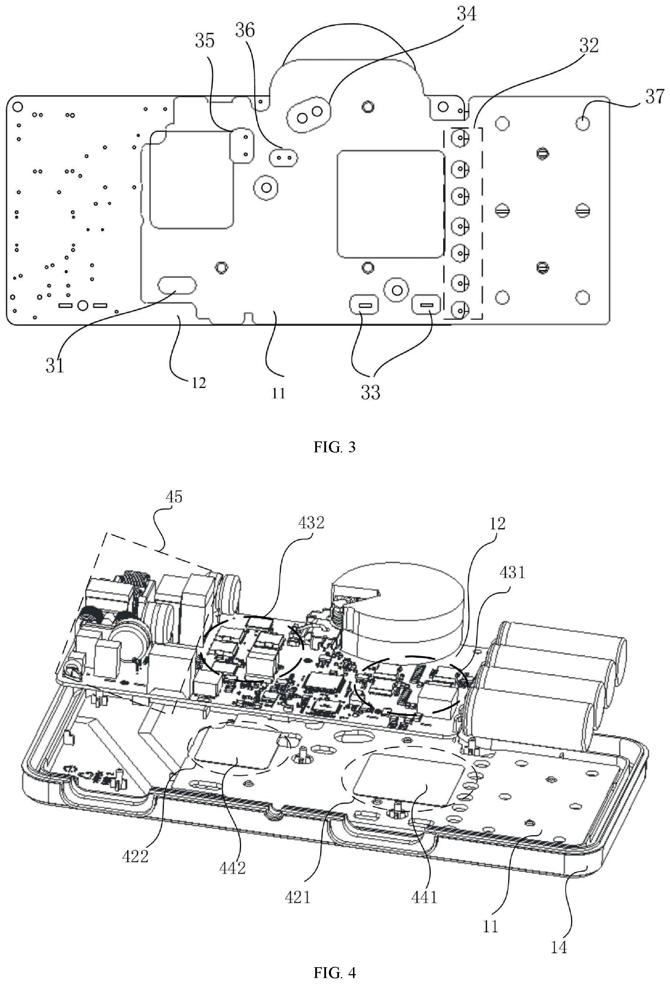

In some embodiments, illustratively, FIG. 2B is a schematic view showing an arrangement of the heat spreader plate 11 and an EMI filter circuit. As shown in FIG. 2B, the heat spreader plate 11 covers circuits in the primary side region and secondary side region of the circuit board 12, and the heat spreader plate 11 does not extend to the region (such as the EMI filter circuit region 45 shown in FIG. 4) where the EMI filter circuit is located, thereby preventing the heat spreader plate 11 from bypassing the EMI filter circuit, and improving the effect of restraining the EMI.

If the heat spreader plate 11 in FIG. 2B is configured to extend to such a position that the projection thereof covers the EMI filter circuit region, in this case, as there is parasitic capacitance between the heat spreader plate 11 and the circuit board 12, a low impedance channel will be formed between the parasitic capacitance and the heat spreader plate 11, so that the EMI generated in the secondary side region will be directly emitted through the low impedance channel without passing through the EMI filter circuit, and that the EMI filter circuit cannot achieve the effect of filtering, thus resulting in poor effect of restraining EMI noises. Based on such considerations, in the present disclosure, the heat spreader plate 11 is configured to not cover the EMI filter circuit region in the secondary side region, thereby improving the effect of restraining the EMI.

If the heat spreader plate 11 shown in FIG. 2A is configured to extend to such a position that the projection thereof covers the EMI filter circuit region, as shown in FIG. 2A, there are many component pins 22 in the EMI filter circuit region on the circuit board 12, so in order to meet the safety requirements, it is necessary to configure densely packed pin openings at positions on the heat spreader plate 11 corresponding to the EMI filter circuit region to avoid the large number of component pins 22. Configuring these pin openings will cause additional process costs, therefore, in the present disclosure, the heat spreader plate 11 is configured to not cover the EMI filter circuit region in the secondary side region, so as to reduce the process cost and ensure a good heat dissipation effect.

### Embodiment 4

A transformer may also be arranged in the target region, and the transformer is connected across the primary side region and the secondary side region.

In the above embodiment, a portion of the heat spreader plate 11 is configured to extend below a magnetic core of the transformer and connected across the primary side pins and the secondary side pins of the transformer, while covering the circuits in the primary side region and secondary side region, thus forming an electromagnetic shielding layer inside the electronic device, thereby effectively restraining the EMC noises.

It should be noted that the circuit board in the present disclosure is a circuit board assembly formed by installing various electronic components, such as resistors, capacitors, inductors, diodes, transistors, integrated circuits, etc., on a printed circuit board (PCB) through surface mount technology (SMT) or plug-in technology, and by performing a series of processes such as welding, cleaning, and testing.

In some embodiments, a first group of through holes are formed in the heat spreader plate 11, and the projections of the first group of through holes along the first direction X are located in the primary side region, and the first group of through holes are configured for insulation.

In some embodiments, a second group of through holes are formed in the heat spreader plate 11, and the projections of the second group of through holes along the first direction X are located in the secondary side region, and the second group of through holes correspond to the component pins in the secondary side region.

In some embodiments, the second group of through holes can be used for meeting safety requirements, and can be used to avoid component pins in the secondary side region on the circuit board 12.

In the present disclosure, the projection of the heat spreader plate 11 along the first direction covers the circuits in the primary side region, so the heat spreader plate 11 can be regarded as a part of the circuits in the primary side region. The safety standard requires that the components in the primary side region must be separated from the components in the secondary side region on the circuit board 12 by a certain distance (for example, 6.3 mm). In order to meet the safety requirements, openings are formed at positions on the heat spreader plate 11 corresponding to the component pins in the secondary side region, so that the heat spreader plate 11 (including the components in the primary side region) are separated from the components in the secondary side region by a safe distance.

If the heat spreader plate 11 is regarded as a part of the circuit of the secondary side region, then in order to meet the requirements, openings are necessarily formed on the heat spreader plate 11 at positions corresponding to the component pins in the primary side region. If relatively more openings are formed corresponding to the primary side region, a large continuous region cannot not be formed corresponding to the primary side region for heat dissipation, thus the heat dissipation effect would be poor and the manufacturing complexity would be relatively high. Therefore, the embodiment of the present disclosure does not adopt such a configuration, but adopts the above configuration where the heat spreader plate 11 is regarded as a part of the circuit of the primary side region, and openings are formed in the heat spreader plate 11 at positions corresponding to the component pins in the secondary side region.

Exemplarily, FIG. 3 is a second schematic view of the circuit board 12 and the heat spreader plate 11. As shown in FIG. 3, the first group of through holes include at least one of: a first-type through hole 31, a second-type through hole 32, a third-type through hole 33, a fourth-type through hole 34, or a fifth-type through hole 36. The projection of the first-type through hole 31 along the first direction X corresponds to a communication transformer pin in a power line communication (PLC). The projection of the second-type through hole 32 along the first direction X corresponds to a capacitor pin. The projection of the third-type through hole 33 along the first direction X corresponds to a connector. The projection of the fourth-type through hole 34 along the first direction X corresponds to a pin of the transformer in the primary side region. The projection of the fifth-type through hole 36, and the projection of the fifth-type through hole 36 along the first direction X correspond to a sampling pin of a current transformer CT.

Exemplarily, as shown in FIG. 3, the second group of through holes are formed in the heat spreader plate 11, and the second group of through holes include the sixth-type through hole 35. The projection of the sixth-type through hole 35 along the first direction X corresponds to a pin of the transformer in the secondary side region.

It should be noted that the through holes and the pins of the components shown in FIG. 3 are illustrative. In the embodiments of the present disclosure, the specific positions and quantities of the through holes in the heat spreader plate 11 and the specific positions and quantities of the pins on the circuit board 12 are not limited, and can be set according to actual needs.

In the present disclosure, the heat spreader plate 11 can be connected to the circuit board 12 through a thermal conductive adhesive filling the gap between the heat spreader plate 11 and the circuit board 12.

Exemplarily, the material of the thermal conductive adhesive may be silica gel, and the thermal conductive adhesive may have good thermal conductivity to conduct the heat of the circuit board 12 quickly to the heat spreader plate 11 to achieve good heat dissipation.

Exemplarily, the heat spreader plate 11 in the electronic device includes a thermal adhesive coating region, and a projection of the thermal conductive adhesive coating region along the first direction X coincides with the high-power consumption component regions.

The high-power consumption component regions may include the first region and/or the second region. High-power consumption components are arranged in the high-power consumption component region. Exemplarily, a component in the high-power consumption component region may be a MOSFET.

Exemplarily, FIG. 4 is a schematic view of a partial structure of the electronic device. As shown in FIG. 4, the heat spreader plate 11 in the electronic device includes the thermal adhesive coating region, and the thermal conductive adhesive coating region includes a first coating region 421 and a second coating region 422. The projection of the first coating region 421 along the first direction X coincides with the high-power consumption component region 431 in the primary side region, and the projection of the second coating region 422 along the first direction X coincides with the high-power consumption component region 432 in the secondary side region.

The high-power consumption component region 431 in the primary side region and the high-power consumption component region 432 in the secondary side region are two main high-heating regions. Thermal conductive adhesive is arranged in these two regions, so that not only the amount of thermal conductive adhesive can be saved, but also the heat in the high-heating regions can be prevented from being transferred to other low-heating regions to cause the components in other low-heating regions to be damaged.

In some embodiments, as shown in FIG. 4, a first protrusion 441 and a second protrusion 442 are disposed on the heat spreader plate 11. The first coating region 421 is disposed on the first protrusion 441, and the second coating region 422 is disposed on the second protrusion 442. The first protrusion 441 and the second protrusion 442 are protrusion structures integrally formed on the heat spreader plate 11.

In some embodiments, the heat spreader plate 11 may not be provided with any coating region, but only provided with a protrusion, and the projection of the protrusion along the first direction X coincides with the high-power consumption component region. Exemplarily, the protrusion disposed on the heat spreader plate 11 may be the first protrusion 441 and/or the second protrusion 442 as shown in FIG. 4, and the high-power consumption component region may be the high-power consumption component region 431 in the primary side region and/or the high-power consumption component region 432 in the secondary side region shown in FIG. 4. The protrusion may not be coated with any thermal conductive adhesive.

In the above embodiments, the protrusions (such as the first protrusion 441 and/or the second protrusion 442) are disposed on the heat spreader plate 11, so that the protrusions can be better in contact with the circuit board 12 (or the high-power consumption component region on the circuit board 12, such as the high-power consumption component region 431 in the primary side region and/or the high-power consumption component region 432 in the secondary side region), and can conduct the heat of the circuit board 12, thereby increasing a heat-conducting volume of the heat spreader plate 11, and achieving a better heat dissipation effect.

In some embodiments, a thickness of the heat spreader plate 11 is greater than or equal to 0.5 mm.

The heat spreader plate 11 is configured to have a relatively large thickness (i.e., greater than 0.5 mm), so that the heat dissipation effect thereof can be better.

In some embodiments, the heat spreader plate 11 is made of metal material. The heat spreader plate 11 can be made of a whole piece of metal material, and the whole piece of metal plate makes the manufacturing process relatively simple, thus saving manufacturing costs. The heat spreader plate 11 can be an aluminum plate or a copper plate. Since metal material has good thermal conductivity, the heat spreader plate 11 made of metal material can better dissipate heat for the circuit board. Since the metal material also has good electrical conductivity, the heat spreader plate 11 made of metal material enables the EMI (an electromagnetic wave) to form a closed loop on the heat spreader plate 11, thereby reducing the electromagnetic waves emitted outward, and improving the effect of restraining EMI.

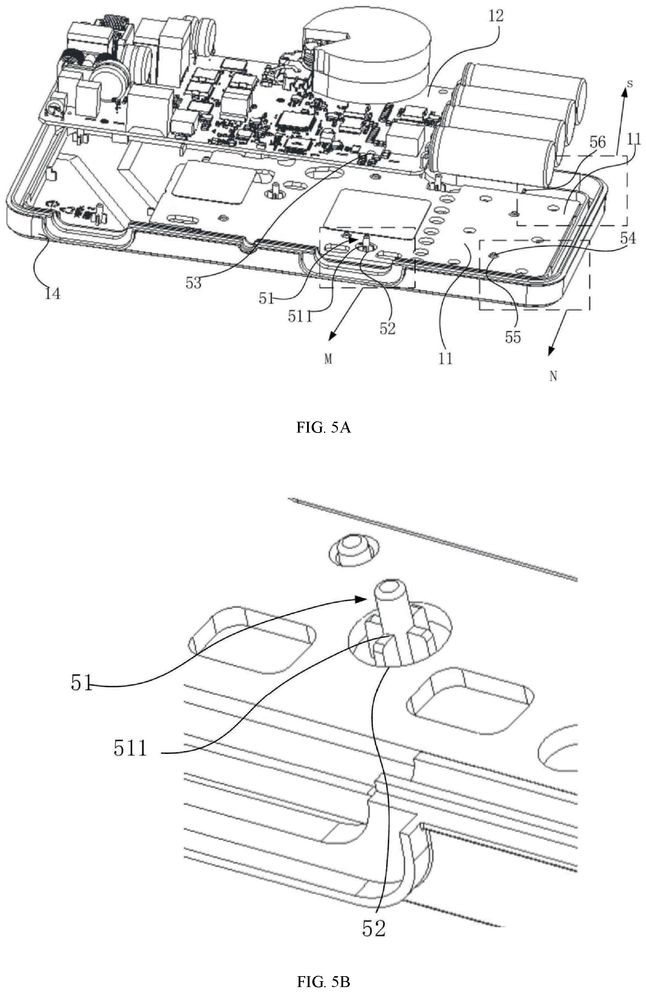

Exemplarily, FIG. 5A is a schematic view showing a fixing structure between a lower housing 14 and a heat spreader plate 11. As shown in FIG. 5A, a first positioning post 51 is disposed on one side of the lower housing 14 proximate to the heat spreader plate 11 and is adapted to extend along the first direction X. A first positioning hole 52 is formed in the heat spreader plate 11, a limiting hole 53 is formed in the circuit board 11, and the first positioning post 51 passes through the first positioning hole 52 and the limiting hole 53 in sequence.

In some embodiments, the first positioning post 51 includes a support pedestal 511, the circuit board 12 is supported on the support pedestal 511, and a height of the support pedestal 511 is greater than the thickness of the heat spreader plate 11.

Exemplarily, the support pedestal 511 may be in a cross shape, and the support pedestal 511 may be configured not only for positioning the heat spreader plate 11, but also for positioning the circuit board 12.

Exemplarily, the support pedestal 511 may be 1 mm higher than the heat spreader plate 11, so that the distance between the heat spreader plate 11 and the circuit board 12 is 1 mm, allowing for coating the thermal conductive adhesive.

In the above embodiments, the first positioning post 51 is configured to fix the heat spreader plate 11, support the circuit board 12, and restrain a lateral movement of the circuit board 12.

In some embodiments, a second positioning post 54 is disposed on the lower housing 14, a second positioning hole 55 is formed on the heat spreader plate 11, the second positioning post 54 is adapted to be inserted into the second positioning hole 55, and a height of the second positioning post 54 is the same as the thickness of the heat spreader plate 11.

In the above embodiment, the second positioning post 54 can be configured to restrain a lateral movement of the heat spreader plate 11.

In some embodiments, as shown in FIG. 5A, the lower housing 14 is further provided with a plurality of positioning members 56 arranged along an edge of the heat spreader plate 11.

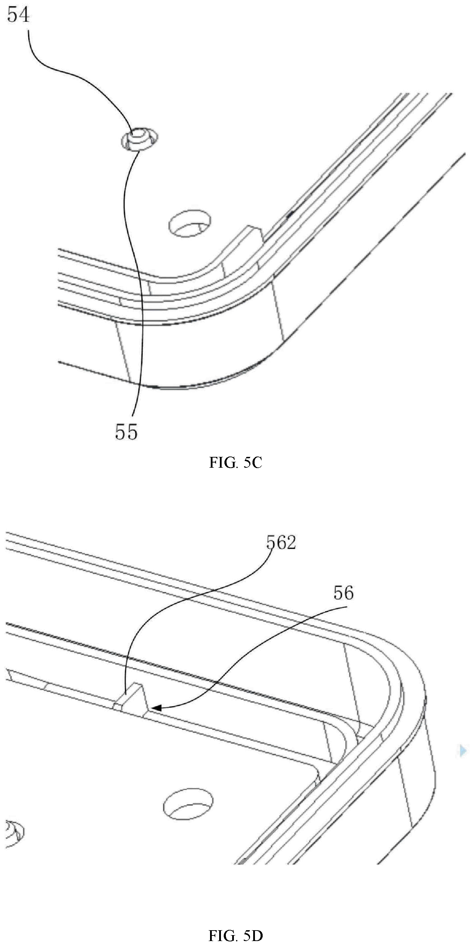

FIG. 5B is a partial enlarged view of a portion M in FIG. 5A, FIG. 5C is a partial enlarged view of a portion N in FIG. 5A, and FIG. 5D is a partial enlarged view of a portion S in FIG. 5A. As can be seen from FIG. 5D, each positioning member 56 can include an abutment portion 562, and the abutment portion 562 is adapted to abut against an outer side wall of the heat spreader plate 11. A fixing structure between the lower housing 14 and the circuit board 11 can be seen from FIG. 5A, FIG. 5B, FIG. 5C and FIG. 5D.

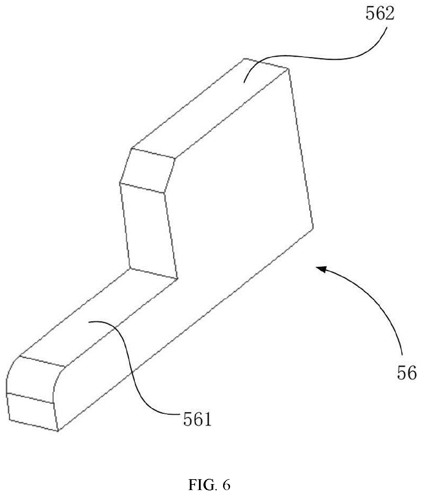

Exemplarily, FIG. 6 is a schematic structural view of a positioning member 56. As shown in FIG. 6, the positioning member 56 may include a support portion 561 and the abutment portion 562 connected to each other. The heat spreader plate 11 is supported on the support portion 561, and the outer side wall of the heat spreader plate 11 abuts against the abutment portion 562.

The support portion 561 is adapted to support the heat spreader plate 11. The abutment portion 562 is adapted to abut against an edge of the heat spreader plate 11 to restrain a lateral movement of the heat spreader plate 11.

In some embodiments, the height of the abutment portion 562 is greater than the thickness of the heat spreader plate 11, thus restraining the lateral movement of the heat spreader plate 11.

In some embodiments, as shown in FIG. 3, an adhesive leakage hole 37 is formed in the heat spreader plate 11. Six adhesive leakage holes are shown in FIG. 3 exemplarily, and the quantity of adhesive leakage holes 37 may be set as required in practice. The adhesive leakage hole 37 is configured to allow adhesive to quickly flow through the heat spreader plate 11.

The adhesive is used for sealing all components between the upper housing 13 and the lower housing 14 to prevent moisture from affecting the components. The adhesive leakage hole 37 allows the adhesive flowing to the heat spreader plate 11 to flow through the heat spreader plate 11 quickly, thereby ensuring that the adhesive flows to all positions, so that the adhesive can be more evenly distributed in the housing without generating bubbles.

The above-described embodiments may be arbitrarily combined. To make the description concise, not all possible combinations of the technical features in the above-described embodiments are described. However, as long as there is no contradiction in the combinations of these technical features, the combinations should be considered to be within the scope of this specification.

The embodiments above are only several implementation modes of the present disclosure, and the description thereof is relatively specific and detailed, but should not be construed as limiting the scope of the patent. It should be noted that for those ordinary skilled in the art, various modifications and improvements may be made without departing from the concept of the present disclosure, and all these modifications and improvements are within the protection scope of the present disclosure. Therefore, the scope of protection of the patent disclosure should be subject to the appended claims.

The subject-matter of the present invention relates, inter alia, to the following aspects:
1. An electronic device, characterized in that the electronic device comprises a housing, a heat spreader plate and a circuit board;
   the housing comprises an upper housing and a lower housing; the lower housing, the heat spreader plate, the circuit board and the upper housing are arranged in sequence along a first direction; and
   a projection of the heat spreader plate along the first direction covers at least a target region of the circuit board.
2. The electronic device according to aspect 1, wherein the target region comprises a first region on the circuit board, wherein components on the first region have a power consumption greater than a first preset threshold.
3. The electronic device according to aspect 1, wherein the target region comprises a primary side region on the circuit board, and a second region in a secondary side region, wherein components on the second region have a power consumption greater than a second preset threshold.
4. The electronic device according to any one of aspects 1 to 3, wherein an electromagnetic interference (EMI) filter circuit region in a secondary side region on the circuit board is located outside the target region.
5. The electronic device according to any one of aspects 1 to 3, wherein a transformer is arranged in the target region, and the transformer is connected across a primary side region and a secondary side region.
6. The electronic device according to aspect 3, wherein a first group of through holes are formed in the heat spreader plate, and projections of the first group of through holes along the first direction are located in the primary side region, and the first group of through holes are configured for insulation.
7. The electronic device according to aspect 6, wherein the first group of through holes comprise at least one of: a first-type through hole, a second-type through hole, a third-type through hole, a fourth-type through hole, or a fifth-type through hole;
   a projection of the first-type through hole along the first direction corresponds to a communication transformer pin in a power line communication (PLC);
   a projection of the second-type through hole along the first direction corresponds to a capacitor pin;
   a projection of the third-type through hole along the first direction corresponds to a connector;
   a projection of the fourth-type through hole along the first direction corresponds to a pin of the transformer in the primary side region; and
   a projection of the fifth-type through hole along the first direction correspond to a sampling pin of a current transformer (CT).
8. The electronic device according to aspect 3, wherein a second group of through holes are formed in the heat spreader plate, projections of the second group of through holes along the first direction are located in the secondary side region, and the second group of through holes correspond to component pins in the secondary side region.
9. The electronic device according to aspect 8, wherein the second group of through holes comprise a sixth-type through hole; and a projection of the sixth-type through hole along the first direction corresponds to a pin of the transformer in the secondary side region.
10. The electronic device according to aspect 2 or 3, wherein the heat spreader plate comprises a thermal conductive adhesive coating region, and a projection of the thermal conductive adhesive coating region along the first direction coincides with high-power consumption component regions.
11. The electronic device according to aspect 10, wherein the thermal conductive adhesive coating region comprises a first coating region and a second coating region;
   a projection of the first coating region along the first direction coincides with a high-power consumption component region in the primary side region; and
   a projection of the second coating region along the first direction coincides with a high-power consumption component region in the secondary side region.
12. The electronic device according to aspect 11, wherein a first protrusion and a second protrusion are disposed on the heat spreader plate; the first coating region is disposed on the first protrusion, and the second coating region is disposed on the second protrusion.
13. The electronic device according to aspect 1, wherein the heat spreader plate is provided with a protrusion, and a projection of the protrusion along the first direction coincides with a high-power consumption component region.
14. The electronic device according to aspect 1, wherein a thickness of the heat spreader plate is greater than or equal to 2 mm.
15. The electronic device according to aspect 1, wherein the heat spreader plate is made of metal material.
16. The electronic device according to aspect 1, wherein a first positioning post is disposed on one side of the lower housing proximate to the heat spreader plate and is adapted to extend along the first direction; a first positioning hole is formed in the heat spreader plate, a limiting hole is formed in the circuit board, and the first positioning post is adapted to pass through the first positioning hole and the limiting hole in sequence.
17. The electronic device according to aspect 16, wherein the first positioning post comprises a support pedestal, the circuit board is supported on the support pedestal, and a height of the support pedestal is greater than a thickness of the heat spreader plate.
18. The electronic device according to aspect 1, wherein a second positioning post is disposed on the lower housing, a second positioning hole is formed on the heat spreader plate, the second positioning post is adapted to be inserted into the second positioning hole, and a height of the second positioning post is the same as a thickness of the heat spreader plate.

## Claims

1. An electronic device, wherein the electronic device comprises a housing, a heat spreader plate (11) and a circuit board (12);
the housing comprises an upper housing (13) and a lower housing (14); the lower housing (14), the heat spreader plate (11), the circuit board (12) and the upper housing (13) are arranged in sequence along a first direction (X); and
a projection of the heat spreader plate (11) along the first direction (X) covers at least a target region of the circuit board (12);
wherein the heat spreader plate (11) is a continuous whole heat spreader plate and made of metal material;
the circuit board (12) comprises a primary side region and a secondary side region; the primary side region is a region where a DC circuit of the circuit board (12) is located, and the secondary side region is a region where an AC circuit of the circuit board (12) is located;
the target region comprises:
a first region on the circuit board (12), wherein components on the first region have a power consumption greater than a first preset threshold;
the primary side region on the circuit board (12), and
a second region in the secondary side region, wherein components on the second region have a power consumption greater than a second preset threshold; and
an electromagnetic interference (EMI) filter circuit region (45) in the secondary side region on the circuit board (12) is located outside the target region.

2. The electronic device according to claim 1, wherein a transformer is arranged in the target region, and the transformer is connected across the primary side region and the secondary side region.

3. The electronic device according to claim 1, wherein a first group of through holes are formed in the heat spreader plate (11), and projections of the first group of through holes along the first direction (X) are located in the primary side region, and the first group of through holes are configured for insulation.

4. The electronic device according to claim 3, wherein the first group of through holes comprise a fourth-type through hole (34), and at least one of: a first-type through hole (31), a second-type through hole (32), a third-type through hole (33), or a fifth-type through hole (36);
a projection of the first-type through hole (31) along the first direction (X) corresponds to a communication transformer pin in a power line communication (PLC);
a projection of the second-type through hole (32) along the first direction (X) corresponds to a capacitor pin;
a projection of the third-type through hole (33) along the first direction (X) corresponds to a connector;
a projection of the fourth-type through hole (34) along the first direction (X) corresponds to a pin of the transformer in the primary side region; and
a projection of the fifth-type through hole (36) along the first direction (X) correspond to a sampling pin of a current transformer (CT).

5. The electronic device according to claim 1, wherein a second group of through holes are formed in the heat spreader plate (11), projections of the second group of through holes along the first direction (X) are located in the secondary side region, and the second group of through holes correspond to component pins in the secondary side region, so that the components on the primary side region are separated from the components on the secondary side region by a safe distance.

6. The electronic device according to claim 5, wherein the second group of through holes comprise a sixth-type through hole (35); and a projection of the sixth-type through hole (35) along the first direction (X) corresponds to a pin of the transformer in the secondary side region.

7. The electronic device according to claim 1, wherein the heat spreader plate (11) comprises a thermal conductive adhesive coating region, and a projection of the thermal conductive adhesive coating region along the first direction (X) coincides with high-power consumption component regions.

8. The electronic device according to claim 7, wherein the thermal conductive adhesive coating region comprises a first coating region (421) and a second coating region (422);
a projection of the first coating region (421) along the first direction (X) coincides with a high-power consumption component region (431) in the primary side region; and
a projection of the second coating region (422) along the first direction (X) coincides with a high-power consumption component region (432) in the secondary side region.

9. The electronic device according to claim 8, wherein a first protrusion (441) and a second protrusion (442) are disposed on the heat spreader plate (11); the first coating region (421) is disposed on the first protrusion (441), and the second coating region (422) is disposed on the second protrusion (442).

10. The electronic device according to claim 1, wherein the heat spreader plate (11) is provided with a protrusion, and a projection of the protrusion along the first direction (X) coincides with a high-power consumption component region.

11. The electronic device according to claim 1, wherein a thickness of the heat spreader plate (11) is greater than or equal to 2 mm.

12. The electronic device according to claim 1, wherein a first positioning post (51) is disposed on one side of the lower housing (14) proximate to the heat spreader plate (11) and is adapted to extend along the first direction (X); a first positioning hole (52) is formed in the heat spreader plate (11), a limiting hole (53) is formed in the circuit board (12), and the first positioning post (51) is adapted to pass through the first positioning hole (52) and the limiting hole (53) in sequence.

13. The electronic device according to claim 12, wherein the first positioning post (51) comprises a support pedestal (511), the circuit board (12) is supported on the support pedestal (511), and a height of the support pedestal (511) is greater than a thickness of the heat spreader plate (11).

14. The electronic device according to claim 1, wherein a second positioning post (54) is disposed on the lower housing (14), a second positioning hole (55) is formed on the heat spreader plate (11), the second positioning post (54) is adapted to be inserted into the second positioning hole (55), and a height of the second positioning post (54) is the same as a thickness of the heat spreader plate (11).

15. The electronic device according to claim 1, wherein a second positioning post (54) is disposed on the lower housing (14), a second positioning hole (55) is formed on the heat spreader plate (11), the second positioning post (54) is adapted to be inserted into the second positioning hole (55), and a height of the second positioning post (54) is the same as the thickness of the heat spreader plate (11).
